(19) Europäisches Patentamt / European Patent Office / Office européen des brevets

(11) **EP 4 390 793 A1**

(12) **EUROPEAN PATENT APPLICATION**

(43) Date of publication:
**26.06.2024 Bulletin 2024/26**

(21) Application number: **22214595.5**

(22) Date of filing: **19.12.2022**

(51) International Patent Classification (IPC):
**G06Q 10/06** (2023.01)     **G06Q 10/063** (2023.01)
**G06Q 10/0631** (2023.01)     **G06Q 10/0637** (2023.01)
**G06Q 10/08** (2024.01)

(52) Cooperative Patent Classification (CPC):
**G06Q 10/0637; B60L 53/80; B60L 58/16; G06Q 10/06; G06Q 10/063; G06Q 10/0631; G06Q 10/08;** B60L 2240/70; B60L 2250/16; B60L 2260/50; B60L 2260/54; G01R 31/392; G08G 1/20

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **VOLVO TRUCK CORPORATION**
**405 08 Göteborg (SE)**

(72) Inventors:
• **ALTAF, Faisal**
  **421 43 VÄSTRA FRÖLUNDA (SE)**
• **FRIDHOLM, Björn**
  **414 62 GÖTEBORG (SE)**
• **KLINTBERG, Anton**
  **414 83 GÖTEBORG (SE)**
• **HELLSTEDT, David**
  **442 72 KÄRNA (SE)**

(74) Representative: **Kransell & Wennborg KB**
**P.O. Box 2096**
**403 12 Göteborg (SE)**

(54) **A METHOD AND SYSTEM FOR ELECTRICAL ENERGY STORAGE MAINTENANCE ON FLEET LEVEL**

(57)     The invention relates to a computer-implemented method for improving lifetimes of electrical energy storages of a fleet of vehicles each associated with one of several missions.

Fig. 2

EP 4 390 793 A1

**Description**

TECHNICAL FIELD

The present disclosure relates to a method for improving lifetimes of electrical energy storages of a fleet of vehicles. The present disclosure also relates to a system, a control unit, a computer program, and a server. Although the method and system will be described in relation to a vehicle in the form of a truck, the method and system can also be efficiently incorporated in other vehicle types such as buses, light-weight trucks, passenger cars, construction equipment, marine vessels, and industrial equipment, as long as they are at least partly electrically propelled.

BACKGROUND

Electrical energy storage systems are becoming a more common source of energy for providing propulsion power to vehicles. Such electrical energy storage systems have multiple rechargeable electrical energy storage packs connected in series and/or in parallel. In addition each of the packs consisting of several electrical energy storage cells that may be connected in series and/or in parallel forming a complete electrical energy storage system for the vehicle.

Batteries are inevitably exposed to ageing, which means that they will lose some of their energy and power capability. In some applications, this means that all or some of the batteries must be replaced after some time. Since the condition of the batteries in a fleet of vehicles significantly affect the operation capability of the fleet, it is of high importance that the replacement is made in an effective manner so that vehicle down-time can be reduced, and fleet operation is optimized.

Further, it may also be important to understand the impact of a replacement on the vehicle fleet performance in terms of for example total range and power, safety attribute, and durability/lifetime characteristics.

Accordingly, it is desirable to improve the methods and systems for performing accurate battery pack replacements.

SUMMARY

An object of the invention is to provide a method and system for improving lifetimes of electrical energy storages of a fleet of vehicles each associated with one of several missions

According to a first aspect of the invention, the object is achieved by a method according to claim 1.

According to the first aspect, there is provided a computer-implemented method for improving lifetimes of electrical energy storages of a fleet of vehicles each associated with one of several missions, the method comprising:

acquiring, by a processor device of a computer system, data indicating hard vehicle fleet performance constraints including: a total energy and power constraints in the fleet's electrical energy storages for fulfilling the fleet missions, and energy and power requirements for fulfilling vehicle missions for individual vehicles,

determining, by the processor device, present state of health (SOH) of each of the electrical energy storages of the fleet,

identifying, by the processor device, electrical energy storages of vehicles in the fleet with SOH such that the energy and power requirement for its mission is not fulfilled,

acquiring, by the processor device, data of warehouse inventory of available electrical energy storages and their SOH,

acquiring, by the processor device, a schedule of planned workshop visits of vehicles of the fleet including the vehicles having electrical energy storages with insufficient SOH and at least one other vehicle of the fleet,

for a given distribution of vehicle missions on a fleet level, determining, by the processor device, a required minimum number of vehicles to fulfil the vehicle missions on the fleet level,

computing, by the processor device, a forecast SOH or an aging prediction for each of the electrical energy storages of the fleet for each of the missions of the fleet,

for the required minimum number of vehicles, computing, by the processor device, an electrical energy storage replacement/reshuffle strategy including a required electrical energy storage distribution among the required minimum number of vehicles that meet the hard constraints with their forecast SOH with minimum margin, and a replacement time slot schedule that minimizes vehicle downtime for reshuffling of electrical energy storage between vehicles and/or replacement from the warehouse by utilizing the already planned workshop visits, and

provide, by the processor device, an instruction including the electrical energy storages replacement/reshuffle strategy.

By the provision of optimizing the electrical energy storage distribution across the fleet so that hard constraints are respected for the fleet, the replacement/reshuffle strategy provides for optimizing the usage and population of the electrical energy storages across the fleet. The replacement/reshuffle strategy ensures that the electrical energy storages are used where they are most efficiently used and provides the highest value to the fleet at a given time, with the requirement that the fleet level hard constrains are respected so that the fleet can accomplish its missions.

Moreover, the optimized replacement strategy provides for extending the total service lifetime of electrical energy storage packs in a vehicle fleet. For example, it is not optimal to keep using and stressing some electrical energy storage packs in some vehicles in a fleet which have harsh missions. In some cases, reshuffling vehicles from one mission to another to extend lifetime and in other cases it may be preferred to shuffle electrical energy storage packs due to limitation of vehicle types in a fleet. Continuously using electrical energy storage packs in one vehicle under harsh condition will most likely lead to shorter lifetime compared to distributing this harsh load on energy storages in multiple vehicles, and this can be avoided by the present invention.

The mission of the fleet includes a set of different missions with different energy and power requirements. Advantageously, the fleet missions include a mix of different missions for different vehicles in the fleet to allow flexibility to do optimization. A mission is set by the energy and power required to take a given cargo from an origin to a destination over a given time duration. A mission may further be defined by the frequency and duration of operations, i.e., how often a given mission is performed and the time duration of the missions.

The method further provides for optimization of warehouse inventory subject to availability of inventory-on-road, i.e., what is the inventory of electrical energy storages in the vehicles in the fleet. This will reduce cost of ware-house inventory and logistics as well as improve availability of parts just in time. In short, it enables lean inventory management of electrical energy storages. That is, the warehouse inventory may be kept considering number of electrical energy storages available for replacement/reshuffling in a fleet i.e., "inventory-on-road". Thus, there is no need to keep inventory to replace all electrical energy storages in vehicles as some vehicles will receive electrical energy storages from other vehicles, i.e., donor vehicles. Due to this flexibility of supply from two sources, the number of electrical energy storages in the warehouse can be reduced.

Determining, by the processor device, present state of health of each of the electrical energy storages of the fleet may include to measure voltage, electrical current, and temperature data of the electrical energy storages.

In examples, the method may comprise determining a power split between a set of electrical energy storages of each electrical energy storage combination; determining an ageing rate or ageing dynamics of the present electrical energy storage configuration based on the determined power split for the classified vehicle usage type and the determined present state of health of the electrical energy storage packs, determining a cost function for the vehicle missions and different electrical energy storage combinations including corresponding state of health levels in each of the electrical energy storage packs, computing the electrical energy storage distribution across the fleet by optimizing the cost function without violating the hard vehicle fleet performance constraints, and computing the electrical energy storage replacement/reshuffle strategy from the computed electrical energy storage distribution.

The cost function may be for the vehicle missions and different electrical energy storage combinations including corresponding state of health levels in each of the electrical energy storage packs, and the impact of electrical energy storage replacement on the determined aging rate.

A cost function may equally well be termed, objective function, reward function, value function, performance index/criteria, cost index/criteria, value index/criteria.

In examples, optimizing the cost function may be to minimize the monetary cost of reshuffling or replacing electrical energy storages while still fulfilling the fleet missions. The cost may be monetary cost/km usage or monetary cost/kWh usage or total cost of fleet operation.

In other examples, the cost function may minimize at least one of: electrical energy storage utilization efficiency, total lifetime energy throughput, minimize $CO_2$ footprint.

It may further be possible to include a consideration in the replacement strategy of the cost of wearing batteries down and their residual value (e.g., price) on the second-hand market where repurposing of batteries in a different vehicle type or application, or even stationary electrical energy storage applications, may be considered. It may even be possible that the replacement strategy considers electrical energy storage pack replacement service cost. In other words, it may be possible to take into account the overall monetary cost of the electrical energy storage replacements and service into the cost function and a potential benefit in a second life application.

Further, the residual value of the used electrical energy storage pack in a secondary application may also be taken into account in the replacement strategy. In such cases, it may be included to retrieve information of possible reuse second applications and including second applications outside the vehicle fleet when computing the electrical energy storage distribution from minimization of the cost function determining, to thereby determine if any electrical energy storages should be reused in a second application.

According to an example embodiment, the method may comprise optimizing the cost function by solving a mixed integer non-linear optimization problem applied to the cost function.

The minimization of the cost function may be iteratively performed with several electrical energy storage configurations until the cost function is minimized without violating the hard constraints.

In examples, identifying, by the processor device, electrical energy storages of vehicles in the fleet with SOH such that the energy requirement for its mission is not fulfilled may comprise: computing, by the processor device, a power split between the electrical energy storages of each vehicle from measurement voltage and electrical current data input to a model; computing, by the processor device, ageing dynamics of the electrical energy storage of each vehicle based on the determined power splits; computing the post-mission SOH of the electrical energy storage of each vehicle from the present SOH and the computed aging dynamics applied to the respective mission, and comparing the post-mission SOH to the respective the energy and power requirement.

Accordingly, the replacement/reshuffle strategy considers load sharing among heterogeneous electrical energy storage packs and the impact it has on energy and power delivery performance of a complete multi-battery system with electrical energy storage packs having mixed state of health. Power split between electrical energy storage packs enables to determine load on each electrical energy storage packs, and with that information regarding load on each electrical energy storage packs the evolution of the performance of each individual electrical energy storage pack can be predicted (i.e., ageing prediction) on long term and how that will affect overall performance of entire multi-electrical energy storage pack system.

The remaining useful life of an electrical energy storage pack in the end of a predetermined time period may be considered in the strategy. This means that a replacement strategy is developed so that the remaining useful life at the end of the predetermined time period exceeds some desired value. Further, a remaining residual value may also be considered in terms of remaining time, cycles etc and residual value in terms of price tag. Residual value is typically calculated after assessment of RUL. The end of a predetermined time period may be at the end of a present set of missions for the fleet of vehicles.

Evaluating power split, or load sharing between the electrical energy storage packs may include to estimate energy and power de-rating using a multi-battery system dynamic model. Using the multi-battery system dynamic model allows for analysing the impact on energy and power capability of a new electrical energy storage system configuration after a certain replacement decision where a combination of replacement electrical energy storage packs and maintained electrical energy storage packs are included. A multi-battery system dynamic model is configured to model power sharing/split dynamics between different electrical energy storage packs in the electrical energy storage system. Since total available energy and power capability of multi-battery electrical energy storage systems depends on this power sharing/split dynamics among battery packs (in addition to their individual energy and power capabilities), and thus affect an estimated total available energy and power capability of the multi-battery electrical energy storage system.

Multi-battery system dynamic models may be realized in different ways, but can take as input, the type of battery packs in terms of cell chemistry, and their present state of health, and provides an output of how the power is split or shared between battery packs, and the total power and energy that can be obtained therefrom. A battery pack may be generally modelled as an equivalent circuit of electrical components such as a resistor in series with a parallel connected capacitor and second resistor. Several such parallel circuits may be connected in series. Several such battery packs may be connected in parallel to simulate a multi-battery system. A dynamic model of a multi-battery system can be developed using various approaches including equivalent circuit, electro-chemical, empirical, semi-empirical etc. The model can be mathematically represented in the form of differential equations, transfer functions, state-space form etc. The model is used for electro-thermal simulation of any multi-battery system, providing: prediction of current/power split between battery packs in electrical energy storage systems i.e., prediction of current flow through each battery pack for a given total energy storage system current, prediction of temperature evolution for each pack under given coolant flow and predicted current flow, prediction of SoC evolution for each battery pack under predicted current flow, in-rush current prediction through each battery pack under connection on the fly. Such a multi-battery system dynamic model may be configurable for any number of batteries along with individual setting of ageing level, state-of-capacity (SoQ) and state-of-resistance (SoR), for each battery pack. In addition, cable connection resistance can be specified for each battery pack. The model may also be particularly useful for estimating overall state of power, SoP, and state of energy, SoE, for heterogeneous ESS. As a reference, the disclosures EP2019/086833, EP2019/086835, EP2020/066874, and EP2020/066919, incorporated by reference, describes variations of such a multi-battery system dynamic model.

Evaluating load sharing or power split between the electrical energy storage packs may further be based on other types of models or even look-up tables where given combinations of electrical energy storage packs are related to minimum state of health levels and load distribution parameters. Further types of models or estimations are also envisaged.

A minimum state of health required according to a classified mission, both on vehicle level and on fleet level, may be concluded from mapping vehicle driving data from previously performed similar or identical mission to deduce electrical energy storage power and energy requirements. A given vehicle mission require a given electrical energy storage total power and energy. With known required electrical energy storage total power and energy, the minimum state of health levels can be estimated or modelled using e.g., predetermined look-up tables or models such as a multi-battery model. For example, in the first life batteries might be used for an aggressive/harsh vehicle application, in the 2nd life it might be used for moderate vehicle usage class, and in the third life it might be useable for mild usage, and so on and so forth until the electrical energy storage pack reaches its absolute end-of-life (i.e., death) that means zero energy and power capability) or reaches its end-of-safe operational limit (i.e., electrical energy storage pack still have some energy and power capability but it cannot be used in a safe way).

State of health may be defined as the loss in capacity relative to a capacity at the beginning of life of the electrical energy storage pack, or the internal resistance increase of the electrical energy storage pack relative the internal resistance at the beginning of life of the electrical energy storage pack. Further, state of health may equally be defined of loss in range, loss in peak acceleration capability, efficiency loss, loss in power-ability etc.

State of health parameters that may be measured for determining a state of health may include at least a state of capacity, a state of resistance, and/or state of power of the electrical energy storage pack. These state of health parameters are well established and advantageously relatively straight-forward to measure and are typically available from automotive electrical energy storage pack management systems (BMS).

Determining ageing dynamics or aging rate of the present electrical energy storage configuration based on the determined power split may include to evaluate the state of health of each electrical energy storage pack to determine how much power can be provided by the electrical energy storage system. This may subsequently be compared to the hard vehicle fleet constraints for power and energy requirements.

With a determined ageing rate under given usage (i.e., load current that is computed based on power split between packs) it can be predicted for how long each electrical energy storage pack will last until it reaches certain minimum performance/productivity threshold. For example, even if one electrical energy storage pack meets performance/productivity requirements at current time, it is not necessary that it meet those requirements after certain time period, such as a remaining contract period. If ageing prediction reveals that electrical energy storage pack performance will degrade much fast in a current application, then it may be decided to use this electrical energy storage pack in another mild application where we can prolong service life. Therefore, future ageing prediction may be included for optimizing the replacement strategy.

The vehicle drive pattern data is historical logged vehicle data regarding actual usage or driving pattern and/or data provided by a user or client regarding the vehicle's intended use. The vehicle drive pattern data is used as input to a classification algorithm to perform classification of the vehicle usage pattern for a given mission. For example, vehicle usage pattern can be classified into "benign/mild", "moderate, or "aggressive". Other types of classifications are also conceivable such as classification according to performance requirements to complete a certain mission or set of missions for the vehicle.

Example performance requirements include peak acceleration, average acceleration, top speed, range, uphill capability, downhill retardation braking capability, charging time capability, over-taking capability, total cargo weight carrying capability etc. In some implementations the classification can also be made according to vehicle type, e.g., construction truck, city distribution truck, reuse collection truck, flat road truck, hilly truck etc. As an example, using the logged vehicle data, the usage pattern is related to a "high/medium/low" peak acceleration, or any one of the other performance requirements.

The classification is preferably made on a relative scale in a fleet of vehicles. Thresholds or intervals in each performance related parameters or requirement and map them towards a certain type of vehicle usage or more generally a label. For example, if acceleration is between 0 and x1 then vehicle usage type is benign, if between x1 and x2 then vehicle usage type is moderate, and if above x2 then vehicle usage type is aggressive. However, other ways of performing classification and mapping are also envisaged.

In a similar way, classification of fleet missions may be performed using logged vehicle drive pattern data. In this way, it may be determined i.e., if fleet mission is harsh, moderate, or mild. For example, this assessment can be made by statistical analysis based on distribution of usage of each individual vehicle mission in a fleet.

Vehicle drive pattern data may be historical driving data as well as data provided by a customer or user for any new vehicle mission requirements.

State of charge, SOC, which is mentioned herein is the present level of charge in the electrical energy storage compared to its full capacity and may be given as a percentage value.

The electrical energy storages are propulsion electrical energy storage and should be interpreted as providing propulsion energy to the vehicle. Thus, the vehicle may be an electrical, hybrid, or plug-in hybrid vehicle comprising an electrical engine, wherein the electrical energy storage provides power to the electrical engine for providing propulsion for the electrical, hybrid, or plug-in hybrid vehicle. The electrical energy storage may be Li-ion electrical energy storage comprising multiple cells arranged in series and in parallel as is known in the art.

An electrical energy storage may herein be considered a electrical energy storage pack.

According to an example embodiment, wherein the electrical energy storage replacement/shuffle strategy includes a message of which vehicles should replace or reshuffle electrical energy storages and which vehicle should receive a reshuffled electrical energy storage. For this, there are identified donor vehicle who will donate an electrical energy storage pack and receiver vehicles who will receive an electrical energy storage pack.

Preferably, the method is performed as a cloud-based service.

According to an example embodiment, the method may comprise applying dynamic programming for minimizing the cost function subject to the hard constraints.

The method may comprise outputting a signal to a remote user interface indicative of that the replacement/reshuffle strategy is recommended to be executed. However, it is also envisaged that a message to display that the electrical energy storage pack replacement strategy is recommended is provided directly in Vehicle's Instrument Cluster. Calculation and evaluation of replacement strategy can take place either on-board or in-cloud and then the replacement decision can be sent out both to vehicle and back-office technical service department or to customers in terms of app-based notification.

The method may be repeated at periodic intervals.

According to a second aspect of the invention, the object is achieved by a system according to claim 10.

According to the second aspect of the invention, there is provided a system for improving lifetimes of electrical energy storages of a fleet of vehicles each associated with one of several missions, the system comprises: a data collector acquiring data indicating hard vehicle fleet performance constraints including: a total energy and power constraints in the fleet of electrical energy storages for fulfilling the fleet missions, and energy and power requirements for fulfilling vehicle missions for individual vehicles, a data acquisitor retrieving present state of health (SOH) data of each of the electrical energy storages of the fleet, a comparator identifying electrical energy storages of vehicles in the fleet with SOH such that the energy requirement for its mission is not fulfilled, a memory storage having stored data of warehouse inventory of available electrical energy storages and their SOH, and a schedule of planned workshop visits of vehicles of the fleet including the vehicles having electrical energy storages with insufficient SOH and at least one other vehicle of the fleet, a control unit configured to: for a given distribution of vehicle missions on a fleet level, determine a required minimum number of vehicles to fulfil the vehicle missions on the fleet level, compute a forecast SOH for each of the electrical energy storages of the fleet for each of the missions of the fleet, for the required minimum number of vehicles, compute an electrical energy storage replacement/reshuffle strategy including a required electrical energy storage distribution among the required minimum number of vehicles that meet the hard constraints with their forecast SOH with minimum margin, and a replacement time slot schedule that minimizes vehicle downtime for reshuffling of electrical energy storage between vehicles and/or replacement from the warehouse by utilizing the already planned workshop visits, and provide an instruction including the electrical energy storages replacement/reshuffle strategy.

The control unit may further be configured to provide the instruction to a user interface and/or to store the electrical energy storage replacement/reshuffle strategy on a memory storage.

Effects and features of the second aspect of the invention are largely analogous to those described above in connection with the first aspect.

According to a third aspect of the invention, there is provided a vehicle comprising the system according to the second aspect.

According to a fourth aspect of the invention, there is provided a computer program comprising program code means for performing the steps the first aspect when the program is run on a computer.

Effects and features of the third, fourth, fifth, and sixth aspects are largely analogous to those described above in relation to the first aspect.

Further features of, and advantages will become apparent when studying the appended claims and the following description. The skilled person will realize that different features may be combined to create embodiments other than those described in the following, without departing from the scope of the present disclosure.

## BRIEF DESCRIPTION OF THE DRAWINGS

With reference to the appended drawings, below follows a more detailed description of embodiments of the invention cited as examples.

In the drawings:

Fig. 1 is a vehicle in the form of an electrical truck according to example embodiments of the invention;

Fig. 2 conceptually illustrates examples of the disclosure;

Fig. 3 is a block diagram of a system according to one example;

Fig. 4 is a flow-chart of method steps according to one example;

Fig. 5 is an example cost function optimization flow according to one example;

Fig. 6 is a flow-chart of method steps according to one example;

Fig. 7 is a flow-chart of method steps according to one example;

Fig. 8 is a schematic diagram of an example computer system.

## DETAILED DESCRIPTION OF EXAMPLE EMBODIMENTS OF THE INVENTION

The present invention will now be described more fully hereinafter with reference to the accompanying drawings, in which exemplary embodiments of the invention are shown. The invention may, however, be embodied in many different forms and should not be construed as limited to the embodiments set forth herein; rather, these embodiments are provided for thoroughness and completeness. The skilled person will recognize that many changes and modifications may be made within the scope of the appended claims.

Like reference character refer to like elements throughout the description.

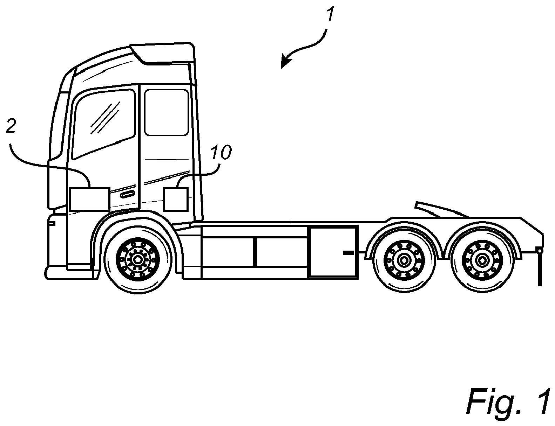

Fig. 1 illustrates a vehicle in the form of an electrical truck 1 comprising a propulsion electrical energy storage system 2 generally comprising a plurality of series and parallel connected electrical energy storage cells. The propulsion electrical energy storage system 2 is arranged to provide power to an electrical engine (not shown) arranged for providing propulsion for the electrical truck 1. The electrical truck 1 further comprises an electrical energy storage managing system 10 which is configured to monitor electrical energy storage cell characteristics such as state of charge (SOC), state of health (SOH), state of power (SOP), state of energy (SOE), state of capacity (SOQ), etc., electrical energy storage voltage, state of resistance (SOR) i.e., internal impedance, and optionally temperature of the electrical energy storage cells. The propulsion electrical energy storage system 2 comprises multiple rechargeable electrical energy storage packs connected in series and/or in parallel. In addition, each of the packs include several electrical energy storage cells that may be connected in series and/or in parallel forming a complete electrical energy storage system 2 for the vehicle. The cells may be Li-ion electrical energy storage cells.

Although the vehicle in fig. 1 is depicted as a heavy-duty truck, embodiments of the present disclosure may as well be implemented in other types of vehicles, such as in buses, light-weight trucks, passenger cars, construction equipment, industrial applications, and marine applications including e.g. vessels or ships.

An electrical energy storage pack may herein be termed a battery.

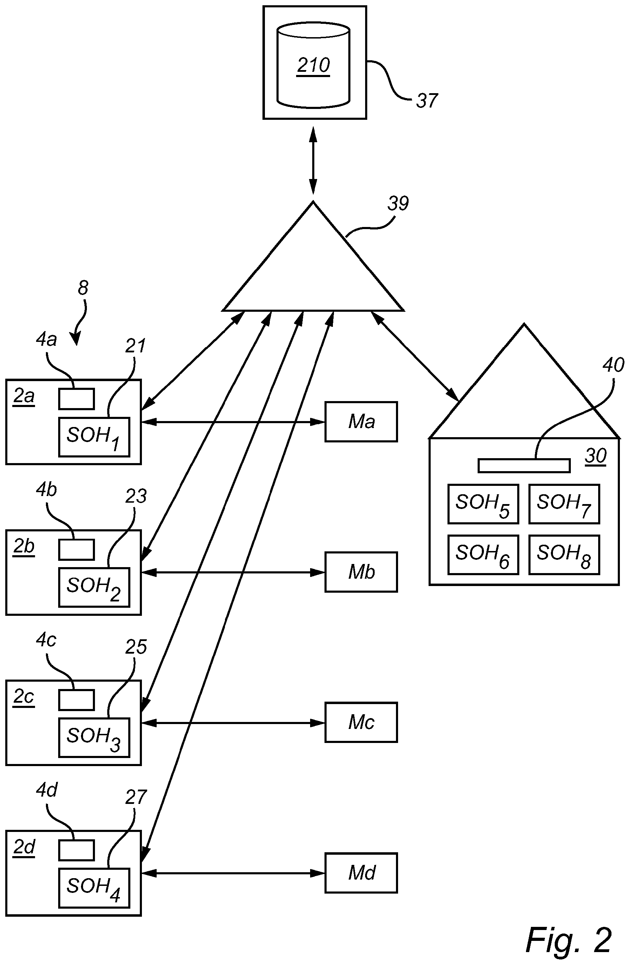

Fig. 2 conceptually illustrates a plurality of electrical energy storages 21, 23, 25, 27, e.g., propulsion batteries of a respective vehicle 2a-2d of a fleet 8. Each of the batteries 21, 23, 25, 27 comprises a plurality of electrical energy storage pack each comprising electrical energy storage cells. Aged battery packs typically have higher internal resistance (i.e., lower power ability) and lower capacity (i.e., lower available energy) and hence the lower maximum power ability and capacity, than a new or less aged electrical energy storage packs based on the same cell chemistry.

Each of the vehicles 2a-2d are associated with a respective mission Ma-Md with energy and power requirements for fulfilling the vehicle missions for the individual vehicles 2a-d. These energy and power requirements are hard constraints since if they are violated, the vehicle cannot fulfil its mission.

There is further shown a processor device 210 of a computer system. The processor device 210 may be provided as a cloud-based service where the processor device 210 is comprised in a server 37. The processor device 210 communicates with communication devices of the vehicles via a communication network 39.

Further, a warehouse 30 includes a storage of a set of electrical energy storages, and a warehouse inventory including data 40 of the available electrical energy storages and their SOH.

The most common replacement strategy is to replace an electrical energy storage pack when its state of health reaches a pre-specified value. However, this may not be an optimal strategy on a fleet level where the overall goal is to accomplish each of the missions Ma-Md. Herein, the efficiency of fleet operations and impact of battery state of health when fulfilling the missions of the entire fleet is considered.

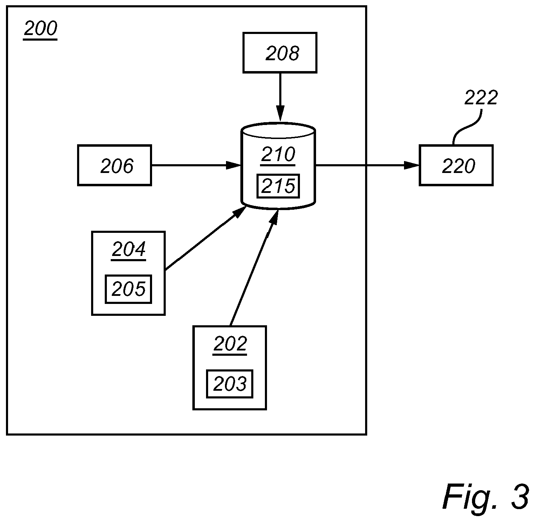

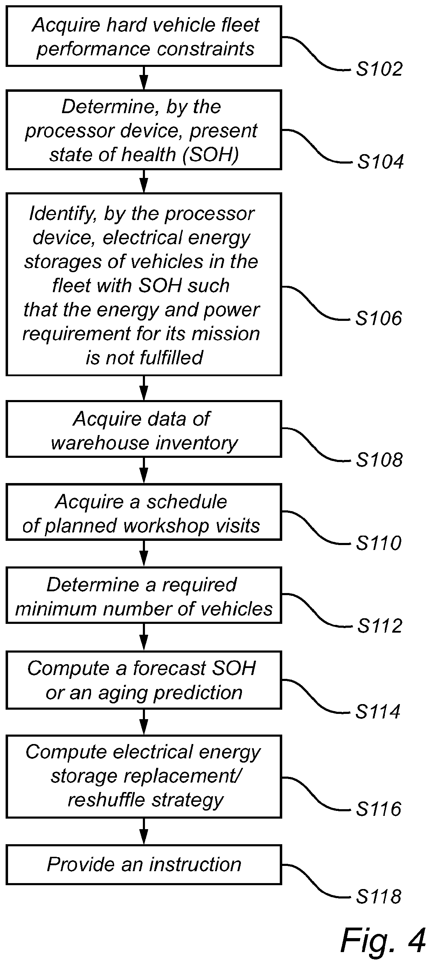

Fig. 3 is a flow-chart of method steps and fig. 4 is a block diagram of a system 200 of embodiments of the present invention.

In step S102, acquiring, by a processor device 210 of a computer system 200, data 203 indicating hard vehicle fleet performance constraints including: a total energy and power constraints in the fleet electrical energy storages for fulfilling the fleet missions, and energy and power requirements for fulfilling vehicle missions for individual vehicles. In other words, the hard constraints are to ensure that the fleet as a whole and that each vehicle of the fleet can achieve its mission. The data 203 is collected by a data collector 202 communicatively connected with the processor device 210.

In step S104, determining, by the processor device 210, present state of health (SOH) of each of the electrical energy storages of the fleet. State of health data 205 is retrieved by a data acquisitor 205 of the computer system 200. For this, the system 200 may utilizes sensors 4a-d configured to collect data indicative of characteristics and parameters of the electrical energy storage system 2. Such sensors 4b may be voltage and/or current sensors for detecting a voltage of each electrical energy storage pack2a-d, or each cell of the electrical energy storage packs 2a-2d, or an electrical discharge of each electrical energy storage pack and/or a charge current of each electrical energy storage pack 2a-2h, or each cell of the electrical energy storage packs 2a-2h. The sensors 4a-d may also include temperature sensors for measuring a temperature of each electrical energy storage pack 2a-2e. Data from the sensors 4b may be used for estimating e.g., SOC, SOH, SOP, SOE, SOQ, etc using BMS.

In step S106, identifying, by the processor device, electrical energy storages 21, 23, 25, 27 of vehicles 2a-d in the fleet with SOH such that the energy and power requirement for its mission is not fulfilled. The identification may be performed by a comparator 206 of the system 200. It is further understood that a mission may further be defined by the frequency and duration of operations, i.e., how often a given mission is performed and the time duration of the missions, and this may also be included in the energy and power requirement for a mission, that is, a more durable mission will cause faster ageing.

Identifying may include computing, by the processor device, a power split between the electrical energy storages of each vehicle from measurement voltage and electrical current data input to a model 215, i.e., a multi-battery system dynamic model. The processor device 210 computes the ageing dynamics or rate of the electrical energy storage 21, 23, 25, 27 of each vehicle 2a-d based on the determined power splits. The processor 210 computes the post-mission SOH of the electrical energy storages 21, 23, 25, 27 of each vehicle 2a-d from the present SOH and the computed aging dynamics applied to the respective mission. The processor 210 compares the post-mission SOH to the respective energy and power requirement to evaluate which of the electrical energy storages 21, 23, 25, 27 cannot fulfil its mission.

In step S108, acquiring, by the processor device, data of warehouse inventory 40 of available electrical energy storages and their SOH. The inventory data 40 is stored on a memory device 208 which also stores a schedule of planned workshop visits of vehicles of the fleet including the vehicles having electrical energy storages with insufficient SOH and at least one other vehicle of the fleet.

In step S110, acquiring, by the processor device, a schedule of planned workshop visits of vehicles of the fleet including the vehicles having electrical energy storages with insufficient SOH and at least one other vehicle of the fleet.

For a given distribution of vehicle missions M1-M4 on a fleet level, determining in step S112, by the processor device 210, a required minimum number of vehicles to fulfil the vehicle missions on the fleet level. Thus, the processor device 210 may calculate with knowledge of the mission and their requirements in energy, power, range, types of cargo, etc, how many vehicles and the vehicle types that are required.

In step S114, computing, by the processor device 210, a forecast SOH or an aging prediction for each of the electrical energy storages 21, 23, 25, 27 of the fleet for each of the missions of the fleet. In other words, the processor 210 makes a prediction of the SOH, or an aging prediction, for each of the electrical energy storages 21, 23, 25, 27 of the fleet for all the missions Ma-Md.

For the required minimum number of vehicles, the processor device 210 computes, an electrical energy storage replacement/reshuffle strategy 220 including a required electrical energy storage distribution among the required minimum number of vehicles that meet the hard constraints with their forecast SOH with minimum margin, and a replacement time slot schedule that minimizes vehicle downtime for reshuffling of electrical energy storage between vehicles and/or replacement from the warehouse by utilizing the already planned workshop visits.

In step S118, providing, by the processor device, an instruction 222 including the electrical energy storage replacement/reshuffle strategy.

The computation of the strategy may be based on minimizing a cost function. For this, each combination of electrical energy storage is evaluated by determining a power split between a set of electrical energy storage packs of each electrical energy storage combination for each vehicle based on the multi-battery model 215. The ageing dynamics of the electrical energy storage combinations is calculated based on the determined power split for the classified vehicle usage type and the determined present state of health of the electrical energy storage packs. A cost function is provided for the vehicle missions and different electrical energy storage combinations including corresponding state of health levels in each of the electrical energy storage packs. The cost function may be for the vehicle missions and different electrical energy storage combinations including corresponding state of health levels in each of the electrical energy storage packs, and the impact of electrical energy storage replacement on the determined aging rate. The processor 210 computes the electrical energy storage distribution across the fleet by optimizing the cost function without violating the hard vehicle fleet performance constraints and calculates the electrical energy storage replacement/reshuffle strategy 220 from the computed electrical energy storage distribution.

Optimizing the cost function may be to minimize the monetary cost of reshuffling or replacing electrical energy storages while still fulfilling the fleet missions. Other possible implementation may be to minimize the SOH degradation of the electrical energy storages on a fleet level while still fulfilling the fleet missions.

The processor 210 may further retrieve information of possible reuse second applications and including second applications outside the vehicle fleet when computing the electrical energy storage distribution from minimization of the cost function, to thereby determine if any electrical energy storages should be reused in a second application. In other words, as a potential receiver of an electrical energy storage system may also second applications be included, for example stationary applications.

Minimizing the cost function is performed by solving a mixed integer non-linear optimization problem applied to the cost function. Further, dynamic programming may be used for minimizing the cost function subject to the hard fleet constraints.

The optimization problem to be solved may be formulated in various ways and next is a mathematical representation of the optimization problem discussed.

The optimization problem may be formulated as:

1: minimize $J(x)$
Subject to

2: $\dot{x}_q = f_q(x_q, y_e, y_t, u)$ being capacity fading dynamics of a electrical energy storage pack, i.e., dynamics of

SoQ.

3: $\dot{x}_r = f_r(x_r, y_e, y_t, u)$ being impedance growth dynamics of a electrical energy storage pack, i.e., dynamics of SoR.

4: $\dot{x}_e = f_e(x_e, x_q, x_r, P_{ess})$, describing dynamics of electrical states of a electrical energy storage packs in a multi-battery system including electrical interactions between them .

5: $y_e = g_e(x_e, x_r, P_{ess})$, is one of the outputs describing dynamics of electrical outputs of a electrical energy storage pack being one example of multi-battery electro-thermal dynamics.

6: $\dot{x}_t = f_t(x_t, u_{heat})$ describing dynamics of thermal dynamics i.e., temperature dynamics of each electrical energy storage pack in a multi-battery ESS including interactions between them being one example of multi-battery electro-thermal dynamics.

7: $y_t = g_t(x_t)$ is one of the output equations describing thermal outputs (e.g., sensor measurement model of surface temperature) of each electrical energy storage pack.

8: $u_{heat} = f_h(y_e)$ describes heat generation in each electrical energy storage pack as a function of electrical outputs (i.e., currents and voltages).

9: $SoH_q^{ess} = f(x_q)$ , the state of health of the electrical energy storage system as a function of SoQ.

10: $SoH_r^{ess} = f(x_r)$ , the state of health of the electrical energy storage system as a function of SoR.

Where constraints are provided by:

11: $SoH_q^{ess} \geq Q_{EoL}^{ess}$ , a constraint on the minimum capacity at the end of life (EoL) of the electrical energy storage system for a given application.

12: $SoH_r^{ess} \leq R_{EoL}^{ess}$ , a constraint on the maximum impedance at the end of life (EoL) of the electrical energy storage system for a given application.

13: $SoH_q^i \geq Q_{EoL}^i$ , a constraint on the minimum capacity at the end of life (EoL) of the individual electrical energy storage packs for a given application.

14: $SoH_r^i \leq R_{EoL}^i$ , a constraint on the maximum impedance at the end of life (EoL) of the individual electrical energy storage packs for a given application.

15: $P_i \leq SoP_i \; \forall i$, a power constraint derived from the driving or usage pattern. Thus, power flow into/out of each electrical energy storage pack must be lower than its state-of-power ability

16: $SOC_L \leq SOC_i \leq SoC_H \; \forall i$, an energy constraint derived from the driving or usage pattern.

Items 9-14 provide aging constrains that serve for the electrical energy storage system to deliver or receive power and store energy in a safe, robust and optimal way. $Q_{EoL}^{ess}$ is the absolute minimum allowed capacity threshold below which ESS cannot performs its main function as described above, i.e., it cannot provide any performance for any application in a safe and robust way.

Further, $R_{EoL}^{ess}$ is the absolute maximum allowed resistance threshold above which the ESS cannot perform its main function for any application in a safe and robust way. This is designated as absolute end-of-life or end-of-safe-life (safe operation of ESS is not possible) or end-of-robust-life (i.e., robust operation of ESS is not possible). For flexibility in optimization different EoL limits are set for complete ESS and individual electrical energy storage packs.

The overall cost function J may be composed of several summed or combined cost functions, Ji, as described in more detail below. The optimization problem may be formulated as, for each given limiting vehicle (not fulfilling its constraints) and each mission, find a new electrical energy storage pack configuration (u) from full battery inventory including warehouse inventory and on-road inventory, that minimizes the total cost J while respecting hard mission constraints. In short, the optimization provides electrical energy storage pack replacement/reshuffling recommendation for each combination of vehicle and mission. A configuration is a combination of electrical energy storage pack with their SoH levels. Among all, the combination of vehicle, mission, and electrical energy storage pack configuration that gives best value J. After finalizing first iteration, the optimization continues with the remaining vehicles, missions, and electrical energy storage pack configurations.

Definitions for the above formulations are provided as:

$\mathbf{u} \in \mathcal{U}$ → ESS configuration / combination, used a main decision/optimization variable.
→ Discrete set of all possible ESS configurations i.e., ESS based on combination of BPs with allowed mix of SoH
$\mathbf{x_q} = [SoQ_1 \cdots SoQ_n]^T$ is a vector of electrical energy storage pack (BP) SoQ:s.
$\mathbf{x_r} = [SoR_1 \cdots SoR_n]^T$ is a vector of BP SoR:s.
$\mathbf{X_e} = [x_{e1}^T \cdots x_{en}^T]^T$ is a vector of BP Electrical States.

$\mathbf{x_{ei}} = [V_{1i} V_{2i} V_{oci} SoC_i]^T$ is a vector of Electrical States of ith BP.

$\mathbf{x_t} = [T_1 \cdots T_n]^T$ is a vector of BP Thermal States.

$\mathbf{y_e} = [SoC^T \ P^T]^T$ is a vector of BP Electrical Ouputs.

$\mathbf{SoC} = [SoC_1 \cdots SoC_n]^T$ is a vector of BP SoC:s.

$\mathbf{P} = [P_1 \cdots Pn]^T$ is a vector of BP Power Shares.

$\mathbf{J} = \Sigma_i J_i$ is the cost Function.

$\mathbf{J_1} = f(x_q, x_r)$ may be a BP SoH dependent Utility cost which is a cost of utilizing the electrical energy storage pack in a current application depending on battery ageing dynamics (capacity fading and impedance growth) i.e., how battery will age and what is the associated cost if we keep using battery in the same application, will this give the best utilization.

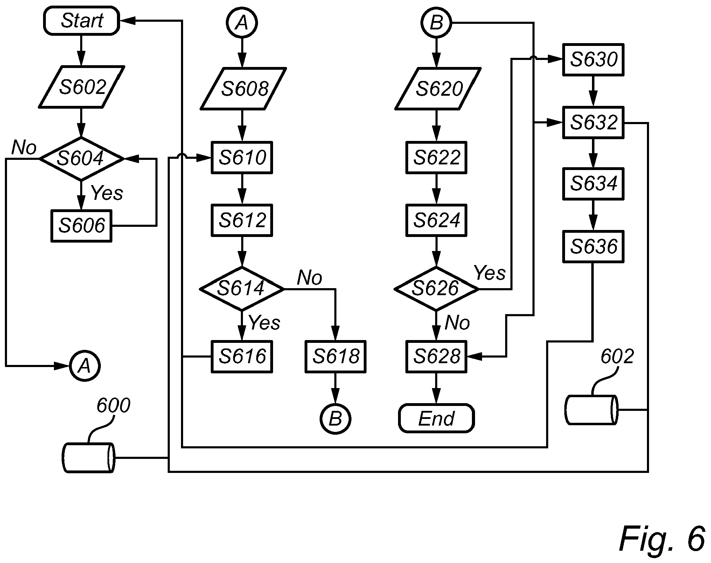

$\mathbf{J_2}$ = *Residual Value of Discarded BPs*: J2 models a residual value of battery if discarded from a current application and reuse it in another application i.e., the residual value of the battery in a second application. Note that the residual value in J2 depends on various factors such as state-of-supply, state-of-demand, state-of-inventory, range of reuse applications etc) shown in relation to the block diagram of Fig 6.

$\mathbf{J_3}$ = *BP Replacement Cost*: J3 models the replacement cost i.e., cost associated with discarding a battery and replacing it with another battery, this includes service cost, logistic cost, part cost etc.

Here, J represent the cost function which itself is composed of various cost factors J1, J2, J3 etc. where J1 is a cost of utilizing battery in a current application depending on battery ageing dynamics (capacity fading and impedance growth) i.e., how battery will age and what is the associated cost if we keep using battery in the same application, will this give the best utilization (i.e., $ per kWh price for utilization) or not. J2 models residual value of battery if we discard it from current application and reuse it in another application i.e., the price that we can charge for this battery from a 2nd user, J3 models the replacement cost i.e., cost that we will have to bear if we discard a battery and replace it with another battery, this includes service cost, logistic cost, part cost etc. Note that the residual value in J2 depends on various factors (state-of-supply, state-of-demand, state-of-inventory, range of reuse applications etc) shown in the left block of Fig 6. Also note that u (i.e., ESS configuration) is used as main decision or optimization variable i.e., we decide which ESS configuration gives us the lowest cost (optimizing cost by smartly choosing ESS configuration for a given application).

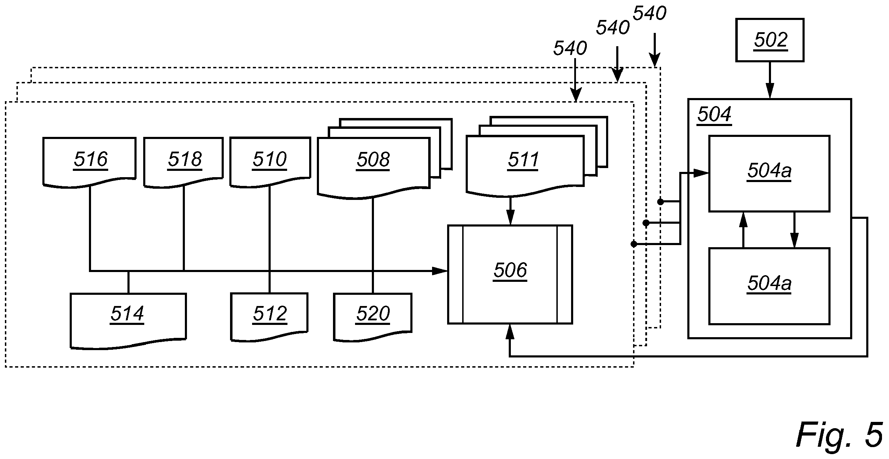

Optimal replacement/reshuffling strategy is achieved by solving a multi-step global optimization problem iteratively with the objective of minimizing the total cost while constraints (ageing dynamics, performance, electrical energy storage system) are respected for all limiting vehicles (nvl), that is, vehicles that cannot fulfil their missions due to the individual power and energy constraints and missions (mv). Decision variables to the optimization problem are which electrical energy storage packs that should be placed in each "limiting vehicle" for each mission and whether those electrical energy storage packs should be supplied from "inventory-on-road" or "inventory-in-warehouse" or both. The problem is solved iteratively i.e., by first finding the best local solution for each vehicle considering full inventory of electrical energy storage packs (on-road and in-warehouse) and set of missions and then out of nvl*mv solutions a solution is selected (i.e., a repaired vehicle 'x' with electrical energy storage configuration 'y' for mission 'z') that gives the best value. After that, continue optimization with respect to nvl-1 limiting vehicles, remaining mv-1 missions, and the remaining inventory. Fig. 5 is an overview of this process.

Turning now to fig. 5, illustrating a cost function minimization flow. Drive or usage pattern data 502 is received and input to a multi-battery system dynamic model 504 that includes modules for modelling multi-battery electro-thermal dynamics 504a and aging dynamics 504b of battery cells. The module 504 is configured to determine the impact on power and energy performance of the battery 2 for the given drive pattern data 502. The impact is quantified for a short time window for the given drive pattern data 502 as well as for more long-time windows for effects on aging due to long term usage.

An optimization module 506 receives the determined power and energy performance of the battery 2 from the multi-battery system dynamic model 504. The optimization module 506 evaluates different configurations 508 of electrical energy storage packs for the present limiting vehicle in view of mission constraints 510 for power and energy requirements for each mission of the fleet. Module 511 stores the requirements such as power and energy requirements for all missions of the fleet. The output of the evaluation is provided to the multi-battery system dynamic model 504 to determine the power and energy performance and how it concurs with state of health and aging. Thus, in each layer 540 in fig. 5, optimization is performed with respect to a given vehicle's original mission and with respect to missions of other vehicles to determine if they can be reassigned to this particular vehicle to gain higher value. For this reason, all missions 511 are fed as input to each layer 540 of the optimization block diagram.

Next, the optimization module 506 receives the power and energy performance for the new configuration and again evaluates different configurations 508 of electrical energy storage packs for the present limiting vehicle. This procedure is looped until the cost function evaluated by the optimization module 506 is minimized with optimal trade-off between vehicle productivity, cost of performing replacement of electrical energy storage packs, and residual value of the electrical energy storage packs. Thus, the flow in fig. 5 conceptually describes solving a constrained nonlinear mixed integer optimization problem iteratively to determine, in step S108, an optimal electrical energy storage configuration for replacement.

The optimal solution is the one that minimizes the cost function.

Other parameters that are considered by the optimization module include data of warehouse inventory (state of inventory) 512 of electrical energy storage packs in a warehouse and data on-road inventory (state of on-road inventory) 513, the present demand (state of demand) 514 in 2nd life market for used batteries, the supply of new batteries (state of supply) 516, and the load cases 518 for specific vehicle (or stationary) load classes where batteries could be reused, and the availability of the workshop performing battery replacements (state of workshop) 520. With regard to 2nd life markets, a battery being used in a first harsh application may be reused in a moderate or mild vehicle application, or it can be used in a stationary energy storage application and may be used even in non-vehicle applications.

Once the optimization is completed for a first vehicle in the fleet, continue optimization with respect to nvl-1, remaining mv-1 missions, and the remaining inventory.

Minimizing the cost function is performed by solving a mixed integer non-linear optimization problem applied to the cost function. The cost function may be one of: the monetary cost of performing the replacement, electrical energy storage utilization efficiency, total lifetime energy throughput, minimize $CO_2$ footprint etc. The cost of operation may also be considered and may be described as monetary cost/km usage or monetary cost/kWh usage or total cost of ownership.

Further, dynamic programming may be used for minimizing the cost function subject to the hard vehicle constraints.

A power split and load sharing of a combination of replacement electrical energy storage pack and maintained electrical energy storage pack may be modelled using e.g., a multi-battery model to determine a load distribution between the electrical energy storage packs after reconfiguration. The control unit 210 is configured to use models, of the added, new or reused electrical energy storage packs, i.e., using the multi-battery model or other types of models or look-up tables, to estimate the distribution of the load between the electrical energy storage packs of each vehicle after replacement. Thus, the mix or combination of replacement electrical energy storage packs and maintained electrical energy storage packs is determined based on what mix and combination that is allowed depending on the energy and power requirements. The hard constraints are used as input for determining the energy and power requirements. As discussed above, model-based estimation of expected power and energy de-rating after replacement may be performed using a multi-battery electrical energy storage system model which allows determining in advance how power sharing occur between batteries after replacement.

The electrical energy storage replacement/reshuffle strategy includes data of which vehicles should have a specific electrical energy storage and when, i.e., a time slot for replacement and/or reshuffle of electrical energy storages.

The method described herein may be repeated at some predetermined interval from the beginning of life to the end of life of the battery, such as every week, every month, every six months, three months, or every month, or once a year and may be performed as an on-board application of the vehicle 1. However, most preferably, the method is implemented as a cloud-based application, i.e., on a server including a control unit for executing the method.

State of health is typically estimated based on capacity loss and/or impedance growth. The end-of-life (EoL) of a battery can be defined according to a certain minimum threshold on remaining capacity or a maximum threshold on impedance increase. For example, when a battery loses 30% of its capacity (i.e., 70% remaining capacity) or gains 50% resistance (i.e., 150% internal impedance) then this can be set as end of life for that battery. These thresholds are dependent on battery chemistry and vehicle application as per performance requirements. Based on this, the value of State of health can be represented in percentage in a relative scale or in an absolute scale.

In a relative scale, state of health is represented on a scale of 0 to 100% relative to the end-of-life threshold where 100% means the electrical energy storage pack is new and 0% means battery has reached its end-of-life (EoL). Furthermore, intermediate multiple ends of lives may be defined based on the present application for the electrical energy storage pack. For example, a first end of life for a first application of an electrical energy storage pack, a second end of life for a second application of the electrical energy storage pack, etc. The second end of life is subsequent to the first end of life.

In an absolute scale state of health is represented in percentage according to the actual percentage loss of capacity or percentage increase in impedance. For example, SoH = 80% when the capacity loss is 20%.

Note that typically maximum 20% to 30% loss in capacity or 50% to 70% increase in impedance is considered in electric vehicle applications.

Fig. 6 is a flow-chart with an overview of possible computer implemented steps according to possible developments of the invention.

In step S602, the overall fleet mission is tracked based on logged driving pattern data of the entire fleet. If the fleet mission constraint involving the total available energy and power of the entire fleet is satisfactory to fulfil the fleet level constraint on total energy and power required for the missions, then fleet operations are continued as is in step S606.

If the fleet mission constraint is not fulfilled, the process continues to step S608, where individual vehicle logged driving pattern data is tracked and compared to energy and power requirements for fulfilling vehicle missions for individual vehicles. In this way, limiting vehicles that are not able to fulfil their missions due to insufficient available energy and power due to degraded electrical energy storage packs can be identified in step S610.

In step S612, the limiting vehicle's performance is evaluated in view of all vehicles missions and their constraints found in database 600. If any of the limiting vehicles can be reshuffled to new mission, they are assigned new missions in step S614. Any remaining vehicles that cannot fulfil any of the other missions in the database 600, are labelled as candidates for electrical energy storage pack reshuffling and/or replacement in step S618.

The electrical energy storage system performance of the labelled candidates are tracked by reading their logged electrical energy storage usage data in step S620. Based on the performance, a narrower set of limiting vehicles are found in step S622 by classifying their individual performance in terms of energy, power and lifetime. In step S624, it is determined if the electrical energy storage packs of any of the limiting set of vehicles from S622 can be reshuffled to one or more of the remaining limiting vehicles. If the outcome is negative in S626, the corresponding electrical energy storage packs are labelled as limiting electrical energy storage packs and are subsequently included in candidates for replacement may be included in a discard electrical energy storage packs list. If the outcome is positive, the method proceeds to step S630.

In step S630, the limiting electrical energy storage packs are labelled as candidates for reshuffling. Data (e.g., SOH) representing these labelled candidates are used for solving the optimization problem discussed above and in conjunction with fig. 5. In other words, the optimization problem is solved in step S632 to find a cost optimal limiting electrical energy storage pack replacement strategy using the here found limiting electrical energy storage pack "inventory on road", "inventory in warehouse" found in database 602, "remaining limiting vehicle", and the database 600 of all vehicle missions.

In step S634, workshop visits of all involved remaining limiting vehicles as well as logistics for limiting electrical energy storage pack flow from warehouse along with maintenance instructions according to the computed optical replacement and reshuffling strategy.

The electrical energy storage pack reshuffling, and replacement is performed, S636, and the vehicles are sent back to operation.

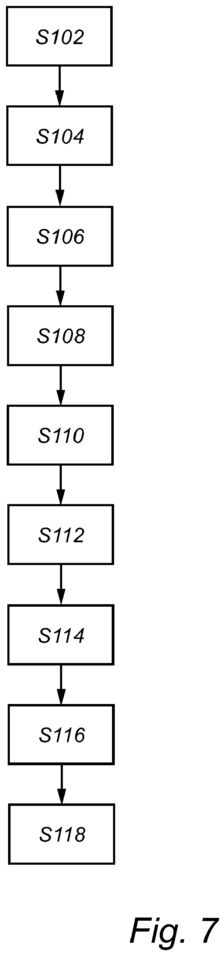

FIG. 7 is a flow chart of a method to improving lifetimes of electrical energy storages of a fleet of vehicles each associated with one of several missions according to one example. The method comprising: acquiring S102), by a processor device of a computer system, data indicating hard vehicle fleet performance constraints including: a total energy and power constraints in the fleet electrical energy storages for fulfilling the fleet missions, and energy and power requirements for fulfilling vehicle missions for individual vehicles, determining S104, by the processor device, present state of health (SOH) of each of the electrical energy storages of the fleet, identifying S106, by the processor device, electrical energy storages of vehicles in the fleet with SOH such that the energy and power requirement for its mission is not fulfilled, acquiring S108, by the processor device, data of warehouse inventory of available electrical energy storages and their SOH, acquiring S110, by the processor device, a schedule of planned workshop visits of vehicles of the fleet including the vehicles having electrical energy storages with insufficient SOH and at least one other vehicle of the fleet, for a given distribution of vehicle missions on a fleet level, determining S112, by the processor device, a required minimum number of vehicles to fulfil the vehicle missions on the fleet level, computing S114, by the processor device, a forecast SOH or an aging prediction for each of the electrical energy storages of the fleet for each of the missions of the fleet, for the required minimum number of vehicles, computing S116, by the processor device, an electrical energy storage replacement/reshuffle strategy including a required electrical energy storage distribution among the required minimum number of vehicles that meet the hard constraints with their forecast SOH with minimum margin, and a replacement time slot schedule that minimizes vehicle downtime for reshuffling of electrical energy storage between vehicles and/or replacement from the warehouse by utilizing the already planned workshop visits, and providing S118, by the processor device, an instruction including the electrical energy storages replacement/reshuffle strategy.

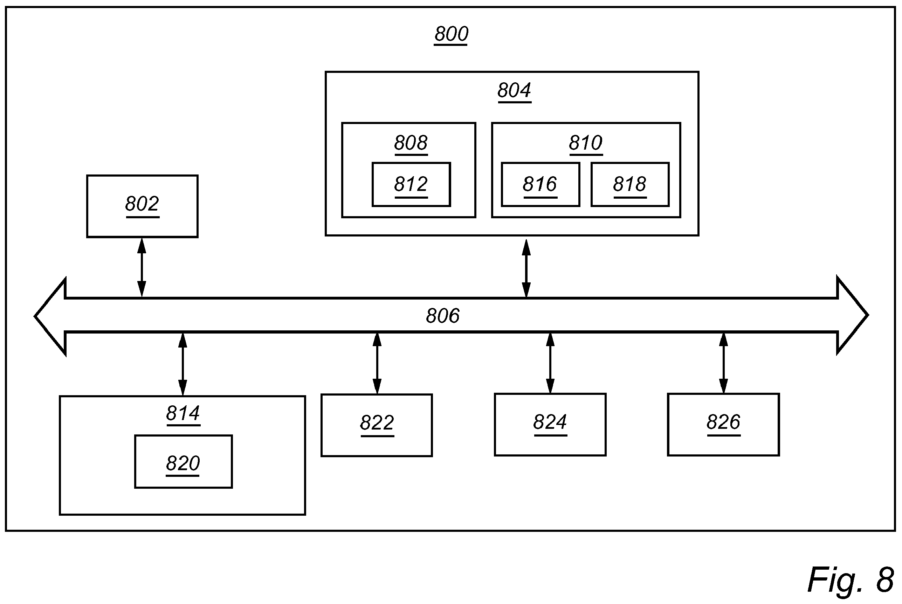

FIG. 8 is a schematic diagram of a computer system 800 for implementing examples disclosed herein. The computer system 800 is adapted to execute instructions from a computer-readable medium to perform these and/or any of the functions or processing described herein. The computer system 800 may be connected (e.g., networked) to other machines in a LAN, an intranet, an extranet, or the Internet. While only a single device is illustrated, the computer system 800 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, etc., includes reference to one or more such devices to individually or jointly execute a set (or multiple sets) of instructions to perform any one or more of the methodologies discussed herein. For example, control system may include a single control unit, or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 800 may comprise at least one computing device or electronic device capable of including firmware, hardware, and/or executing software instructions to implement the functionality described herein. The computer system 800 may include a processor device 802 (may also be referred to as a control unit), a memory 804, and a system bus 806. The computer system 800 may include at least one computing device having the processor device 802. The system bus 806 provides an interface for system components including, but not limited to, the memory 804 and the processor device 802. The processor device 802 may include any number of hardware components for conducting data or signal processing or for executing computer code stored in memory 804. The processor device 802 (e.g., control unit) may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processor device may further include computer executable code that controls operation of the programmable device.

The system bus 806 may be any of several types of bus structures that may further interconnect to a memory bus (with or without a memory controller), a peripheral bus, and/or a local bus using any of a variety of bus architectures. The memory 804 may be one or more devices for storing data and/or computer code for completing or facilitating methods described herein. The memory 804 may include database components, object code components, script components, or other types of information structure for supporting the various activities herein. Any distributed or local memory device may be utilized with the systems and methods of this description. The memory 804 may be communicably connected to the processor device 802 (e.g., via a circuit or any other wired, wireless, or network connection) and may include computer code for executing one or more processes described herein. The memory 804 may include non-volatile memory 808 (e.g., read-only memory (ROM), erasable programmable read-only memory (EPROM), electrically erasable programmable read-only memory (EEPROM), etc.), and volatile memory 810 (e.g., random-access memory (RAM)), or any other medium which can be used to carry or store desired program code in the form of machine-executable instructions or data structures and which can be accessed by a computer or other machine with a processor device 802. A basic input/output system (BIOS) 812 may be stored in the non-volatile memory 808 and can include the basic routines that help to transfer information between elements within the computer system 800.

The computer system 800 may further include or be coupled to a non-transitory computer-readable storage medium such as the storage device 814, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 814 and other drives associated with computer-readable media and computer-usable media may provide non-volatile storage of data, data structures, computer-executable instructions, and the like. A number of modules can be implemented as software and/or hard-coded in circuitry to implement the functionality described herein in whole or in part. The modules may be stored in the storage device 814 and/or in the volatile memory 810, which may include an operating system 816 and/or one or more program modules 818. All or a portion of the examples disclosed herein may be implemented as a computer program product 820 stored on a transitory or non-transitory computer-usable or computer-readable storage medium (e.g., single medium or multiple media), such as the storage device 814, which includes complex programming instructions (e.g., complex computer-readable program code) to cause the processor device 802 to carry out the steps described herein. Thus, the computer-readable program code can comprise software instructions for implementing the functionality of the examples described herein when executed by the processor device 802. The processor device 802 may serve as a controller or control system for the computer system 800 that is to implement the functionality described herein.

The computer system 800 also may include an input device interface 822 (e.g., input device interface and/or output device interface). The input device interface 822 may be configured to receive input and selections to be communicated to the computer system 800 when executing instructions, such as from a keyboard, mouse, touch-sensitive surface, etc. Such input devices may be connected to the processor device 802 through the input device interface 822 coupled to the system bus 806 but can be connected through other interfaces such as a parallel port, an Institute of Electrical and Electronic Engineers (IEEE) 1394 serial port, a Universal Serial Bus (USB) port, an IR interface, and the like. The computer system 800 may include an output device interface 824 configured to forward output, such as to a display, a video display unit (e.g., a liquid crystal display (LCD) or a cathode ray tube (CRT)). The computer system 800 may also include a communications interface 826 suitable for communicating with a network as appropriate or desired.

The operational steps described in any of the exemplary aspects herein are described to provide examples and discussion. The steps may be performed by hardware components, may be embodied in machine-executable instructions to cause a processor to perform the steps, or may be performed by a combination of hardware and software. Although a specific order of method steps may be shown or described, the order of the steps may differ. In addition, two or more steps may be performed concurrently or with partial concurrence.

**Claims**

1. A computer-implemented method for improving lifetimes of electrical energy storages of a fleet of vehicles each associated with one of several missions, the method comprising:

acquiring (S102), by a processor device of a computer system, data indicating hard vehicle fleet performance constraints including: a total energy and power constraints in the fleet electrical energy storages for fulfilling the fleet missions, and energy and power requirements for fulfilling vehicle missions for individual vehicles, determining (S104), by the processor device, present state of health (SOH) of each of the electrical energy storages of the fleet, identifying (S106), by the processor device, electrical energy storages of vehicles in the fleet with SOH such that the energy and power requirement for its mission is not fulfilled, acquiring (S108), by the processor device, data of warehouse inventory of available electrical energy storages and their SOH, acquiring (S110), by the processor device, a schedule of planned workshop visits of vehicles of the fleet including the vehicles having electrical energy storages with insufficient SOH and at least one other vehicle of the fleet, for a given distribution of vehicle missions on a fleet level, determining (S112), by the processor device, a required minimum number of vehicles to fulfil the vehicle missions on the fleet level, computing (S114), by the processor device, a forecast SOH or an aging prediction for each of the electrical energy storages of the fleet for each of the missions of the fleet, for the required minimum number of vehicles, computing (S116), by the processor device, an electrical energy storage replacement/reshuffle strategy including a required electrical energy storage distribution among the required minimum number of vehicles that meet the hard constraints with their forecast SOH with minimum margin, and a replacement time slot schedule that minimizes vehicle downtime for reshuffling of electrical energy storage between vehicles and/or replacement from the warehouse by utilizing the already planned workshop visits, and providing (S118), by the processor device, an instruction including the electrical energy storages replacement/reshuffle strategy.

2. The method of claim 1, computing the strategy comprises, for each combination of electrical energy storage:

determining a power split between a set of electrical energy storages of each electrical energy storage combination; determining an ageing rate or ageing dynamics of the present electrical energy storage configuration based on the determined power split for the classified vehicle usage type and the determined present state of health of the electrical energy storage packs; determining a cost function for the vehicle missions and different electrical energy storage combinations including corresponding state of health levels in each of the electrical energy storage packs, computing (S108) the electrical energy storage distribution across the fleet by optimizing the cost function without violating the hard vehicle fleet performance constraints, and computing the electrical energy storage replacement/reshuffle strategy from the computed electrical energy storage distribution.

3. The method of claim 2, wherein optimizing the cost function minimizes the monetary cost of reshuffling or replacing electrical energy storages while still fulfilling the fleet missions.

4. The method of claim 2, wherein optimizing the cost function minimizes the SOH degradation of the electrical energy storages on a fleet level while still fulfilling the fleet missions.

5. The method of any of claims 2 to 4, comprising retrieving information of possible reuse second applications, and including second applications outside the vehicle fleet when computing the electrical energy storage distribution from minimization of the cost function determining, to thereby determine if any electrical energy storages should be reused in a second application.

6. The method according to any one of claims 2 to 5, optimizing the cost function is performed by solving a mixed integer non-linear optimization problem applied to the cost function.

7. The method according to any one of the preceding claims, wherein determining, by the processor device, present state of health of each of the electrical energy storages of the fleet includes measuring voltage, electrical current, and temperature data of the electrical energy storages.

8. The method according to any one of the preceding claims, wherein identifying, by the processor device, electrical energy storages of vehicles in the fleet with SOH such that the energy requirement for its mission is not fulfilled, comprises:

computing, by the processor device, a power split between the electrical energy storages of each vehicle from measurement voltage and electrical current data input to a model;

computing, by the processor device, ageing dynamics of the electrical energy storage of each vehicle based on the determined power splits;

computing the post-mission SOH of the electrical energy storage of each vehicle from the present SOH and the computed aging dynamics applied to the respective mission, and

comparing the post-mission SOH to the respective the energy and power requirement.

9. The method according to any one of the preceding claims, wherein the mission of the fleet includes a set of different missions with different energy and power requirements.

10. A system (200) for improving lifetimes of electrical energy storages of a fleet of vehicles each associated with one of several missions comprising:

a data collector (202) acquiring data (203) indicating hard vehicle fleet performance constraints including: a total energy and power constraints in the fleet of electrical energy storages for fulfilling the fleet missions, and energy and power requirements for fulfilling vehicle missions for individual vehicles,

a data acquisitor (204) retrieving present state of health (SOH) data of each of the electrical energy storages of the fleet,

a comparator (206) identifying electrical energy storages of vehicles in the fleet with SOH such that the energy requirement for its mission is not fulfilled,

a memory storage (208) having stored data of warehouse inventory of available electrical energy storages and their SOH, and a schedule of planned workshop visits of vehicles of the fleet including the vehicles having electrical energy storages with insufficient SOH and at least one other vehicle of the fleet,

a control unit (210) configured to:

for a given distribution of vehicle missions on a fleet level, determine a required minimum number of vehicles to fulfil the vehicle missions on the fleet level,

compute a forecast SOH for each of the electrical energy storages of the fleet for each of the missions of the fleet,

for the required minimum number of vehicles, compute an electrical energy storage replacement/reshuffle strategy including an required electrical energy storage distribution among the required minimum number of vehicles that meet the hard constraints with their forecast SOH with minimum margin, and a replacement time slot schedule that minimizes vehicle downtime for reshuffling of electrical energy storage between vehicles and/or replacement from the warehouse by utilizing the already planned workshop visits, and

provide an instruction (220) including the electrical energy storages replacement/reshuffle strategy.

11. The system according to claim 10, wherein the control unit is configured to provide the instruction to a user interface and/or to store the electrical energy storage replacement/reshuffle strategy on a memory storage.

12. A computer program product comprising program code for performing, when executed by the processor device, the method of any of claims 1-9.

13. A non-transitory computer-readable storage medium comprising instructions, which when executed by the processor device, cause the processor device to perform the method of any of claims 1-9.

14. A control system comprising one or more control units configured to perform the method of any of claims 1-9.

15. A server comprising the control unit according to claim 14.

Fig. 1

*Fig. 2*

Fig. 3

Acquire hard vehicle fleet
performance constraints — S102

Determine, by the
processor device, present
state of health (SOH) — S104

Identify, by the processor
device, electrical energy
storages of vehicles in the
fleet with SOH such
that the energy and power
requirement for its mission
is not fulfilled — S106

Acquire data of
warehouse inventory — S108

Acquire a schedule
of planned workshop visits — S110

Determine a required
minimum number of vehicles — S112

Compute a forecast SOH
or an aging prediction — S114

Compute electrical energy
storage replacement/
reshuffle strategy — S116

Provide an instruction — S118

Fig. 4

Fig. 5

Fig. 6

Fig. 7

Fig. 8

EP 4 390 793 A1

Europäisches
Patentamt

European
Patent Office

Office européen
des brevets

# EUROPEAN SEARCH REPORT

**Application Number**

**EP 22 21 4595**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 079 505 B1 (HYDE RODERICK A [US] ET AL) 14 July 2015 (2015-07-14) <br> * columns 16,21-23; figures 1-31 * <br> * columns 26,48 * <br> ----- | 1-15 | INV. <br> G06Q10/06 <br> G06Q10/063 <br> G06Q10/0631 <br> G06Q10/0637 <br> G06Q10/08 |

**TECHNICAL FIELDS SEARCHED (IPC)**

G06Q

The present search report has been drawn up for all claims

| Place of search | Date of completion of the search | Examiner |
|---|---|---|
| Munich | 12 May 2023 | Bîrlescu, V |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

........................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 22 21 4595

This annex lists the patent family members relating to the patent documents cited in the above-mentioned European search report.
The members are as contained in the European Patent Office EDP file on
The European Patent Office is in no way liable for these particulars which are merely given for the purpose of information.

12-05-2023

| Patent document cited in search report | Publication date | Patent family member(s) | Publication date |
|---|---|---|---|
| US 9079505 B1 | 14-07-2015 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2019086833 A
- EP 2019086835 A
- EP 2020066874 A
- EP 2020066919 A